# EUROPEAN PATENT SPECIFICATION

(11) **EP 2 033 309 B1**
(45) Date of publication and mention of the grant of the patent: **19.08.2015**
(21) Application number: 07870685.0
(22) Date of filing: 15.05.2007
(51) Int. Cl.: H01P 5/10

(54) **TRANSMISSION LINE BALUN FOR BROADBAND COMBINERS, SPLITTERS AND TRANSFORMERS**
ÜBERTRAGUNGSLEITUNGSSYMMETRIESCHALTUNG FÜR BREITBANDKOMBINATOREN, -SPLITTER UND -TRANSFORMATOREN
SYMETRISEUR DE LIGNE DE TRANSMISSION POUR SYSTEMES DE COMBINAISON LARGE BANDE, SEPARATEURS ET TRANSFORMATEURS

(30) Priority: 16.05.2006 US 435360
(43) Date of publication of application: 11.03.2009
(73) Proprietor: Harris Corporation, Melbourne FL 32919 (US)
(72) Inventor: TALBOT, Robert D., Pittsford, NY 14534 (US)
(74) Representative: Schmidt, Steffen
(86) International application number: PCT/US2007/011652
(87) International publication number: WO 2008/069836

(56) References cited:
- GB-A- 2 307 794
- US-A- 2 966 640
- US-A- 4 222 016
- US-A- 4 267 529
- US-A- 4 647 868
- RUBAN V.P.: 'The Strobe Pulse Shaper Built on Strip Line Shielded by Ferrite' ULRAWIDEBAND AND ULTRASHORT IMPULSE SIGNALS 19 September 2004 - 22 September 2004, pages 296 - 298, XP010776886

## Description

This invention relates to transmission line transformers. More particularly, this invention relates to broadband transmission line baluns.

A balanced to unbalanced transformer, also called by its contraction "balun", essentially provides the same characteristics as an isolation transformer that transmits the energy from input to output by a transmission line mode instead of by flux linkages as in the case of conventional transformers.

Baluns allow a grounded source to drive an ungrounded load or a balanced load where the midpoint is grounded. Further, baluns allow phase reversal of the signal. Still further, if a positive signal is applied to its input, the positive output lead could be grounded. If the return current is forced to flow in the shield, then there is no radiated field from the transmission line because, from a point outside the line, both currents are located at the center of the line and cancel each other. Field still exist, however, between the center conductor and the shield.

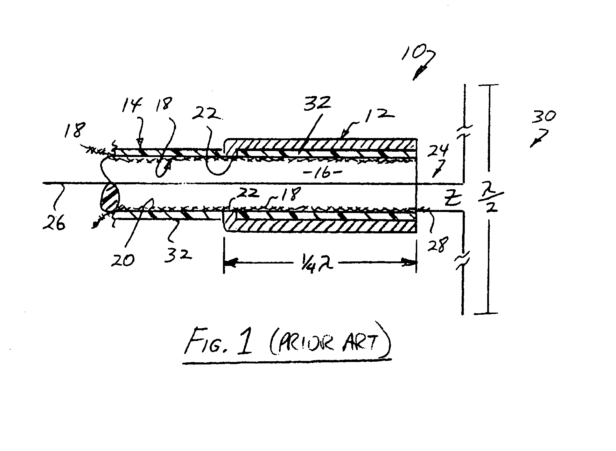

Baluns in the form of a conductive sleeve, also known as bazooka baluns, are commonly used to match balanced antennas to unbalanced coax feeders. A prior art bazooka balun 10 is shown in Fig. 1 as comprising a conductive sleeve 12 of a quarter wavelength long that is positioned over the end 16 of a 75Ω cable 14 and shorted to the shield 18 of the cable 14 (i.e., its unbalanced line 20) only at its proximal end 22 to reflect an open circuit at its feed point 24 of its inner conductor 26. The balanced line 28 constituting the load Z may comprise, as shown, a half-wave dipole antenna 30. The conductive sleeve 12 may fit tightly around the existing outer plastic mantle 32.

Notably, the bazooka balun's sleeve 12 shorted to the shield 18 forms a second coaxial transmission line (i.e., the sleeve being the "shield" of the new line and the original "shield" being the inner conductor). In theory, a perfect lossless quarter wave transmission line would present an infinite impedance at the frequency where it is a quarter of wave long. In practice, however, using a small-diameter sleeve positioned tightly over only the cable's existing outer plastic mantle as the dielectric spacer presents a low impedance. In contrast, a significantly higher impedance can be attained by using a dielectric tubular cylinder installed over the coaxial cable to which a larger-diameter sleeve is then installed. A representative patent showing a larger-diameter sleeve includes U.S. Patent 4,737,797. U.S. Patent 6,552,689 discloses a further modified balun in which a conductive sleeve and a dielectric cylinder of the same diameter are stacked and then positioned within a larger-diameter outer dielectric cylinder.

The impedance and the lower frequency end of the bandwidth may be increased through the use of baluns that employ ferrites in lieu of sleeves. Without the use of ferrite, the inductance of the shield to ground limits the low frequency end.

Prior art ferrite baluns employing ferrite beads have often comprised a plurality of ferrite beads positioned over the cable close to the feed point to maintain a high impedance across the frequency band. See for example, U.S. Patent 4,962,359. Other prior art ferrite baluns have employed ferrite sleeves. See for example, U.S. Patent 4,719,699. Finally, still other ferrite baluns have been incorporated into the frame of a Yagi antenna. See for example, U.S. Patent 4,028,709.

Document US2966640A discloses a coaxial transmission line having an inner conductor and an outer conductor. Associated with the transmission line are a transmission end for transmitting signals along the line and a termination end for receiving signals transmitted along the line. A flexible sheath of conductive material is concentrically disposed about a length of the transmission line. One end of the flexible sheath is secured to the insulation surrounding the outer conductor of the transmission line adjacent to the termination end. The other end of the flexible sheath is conductively coupled to the outer conductor of the transmission line at a point spaced from the termination end.

Document US4222016A discloses a high frequency transformer built from coaxial conductor sections, wherein a pair of coaxial conductor sections of equal length have external conductors which are insulated from each other. The input end of the external conductor of the first coaxial conductor section is connected with the input end of the internal conductor of the second coaxial conductor section and both of the unconnected input end internal and external conductors form input connections. The output end of the internal conductor of the first coaxial conductor section is connected with the output end of the external conductor of the second coaxial conductor section and both of the unconnected output end internal and external conductors form output connections.

Document GB2307794A discloses a linearly polarized antenna having a coaxial line and a dipole antenna member connected to the end of the coaxial line wherein: a pair of slits extending in a longitudinal direction of the coaxial line are provided on an outer conductor of the coaxial line in a section of a prescribed length from the end of the coaxial line, thus splitting the outer conductor into two leafs; one element making up the dipole antenna member is connected at its base side to a center conductor of the coaxial line and to an end of one leaf of the outer conductor; and the other element making up the dipole antenna member is connected at its base side to an end of the other leaf of the outer conductor.

Document US4267529A discloses an apparatus for coupling a source of signals to a receiver having a ground return electrically coupled to the AC line and for providing immunity from interfering ambient signals. The apparatus includes a coaxial transmission line surrounded at both ends by feedthrough capacitor coupling the outer conductor of the transmission line to the ground return of the signal source. A toroidal ferrite member also surrounds the transmission line between the feedthrough capacitors thereby reducing the current flowing in the outer conductor and the resulting direct pickup of ambient signals.

Unfortunately, when using ferrite baluns, a parasitic line is formed by the shield to ground. The parasitic effects of employing ferrite at high frequencies is well documented. U.S. Patent 5,296,823 acknowledges such parasitic effects and teaches specific printed circuit and shielded structures for parasitic mode suppression. Specifically, as illustrated in Fig. 11 thereof, one shielded structure includes the side-by-side positioning of a ferrite core having a central passage containing a two-conductor transmission line and a dielectric having a central passage containing a single-conductor transmission line, into an enlarged shielding tubular signal ground conductor. According to its teachings, the shielded structure confines signal energy and prevents coupling to other outside circuits and structures.

There presently exists a need for an improved balun that isolates the balun from the effects of ferrite at low frequency thereby significantly reducing losses and improving VSWR.

Object of this invention is to provide a balun that employs a ferrite to increase the impedance and the lower frequency end of the bandwidth while isolating the balun from the parasitic effects of ferrite at low frequency and thereby significantly reducing losses and improving VSWR.

The foregoing has outlined some of the pertinent objects of the invention. These objects should be construed to be merely illustrative of some of the more prominent features and applications of the intended invention. Many other beneficial results can be attained by applying the disclosed invention in a different manner or modifying the invention within the scope of the disclosure. Accordingly, other objects and a fuller understanding of the invention may be had by referring to the summary of the invention and the detailed description of the preferred embodiment in addition to the scope of the invention defined by the claims taken in conjunction with the accompanying drawings.

For the purpose of summarizing the invention, the invention comprises a transmission line balun for broadband combiners, splitters and transformers. In general, the balun of the invention comprises a tubular ferrite having a longitudinal passageway. A conductive sleeve is positioned concentrically within the passageway of the tubular ferrite. The length of the tubular ferrite containing the conductive sleeve and the length of the conductive sleeve are both preferably one-quarter of the wavelength. The distal end of the transmission line is positioned into the conductive sleeve and the sleeve is grounded at its proximal end to the shield of the coax. The resulting assembly comprises the coax, the conductive sleeve and the tubular ferrite positioned concentrically with respect to each other at the proximal end of the coax.

More specifically, the balun of the invention comprises a coax cable, with a conducting sleeve surrounding it, and a ferrite sleeve over the conducting sleeve. The sleeves are separated by insulating material. The conducting sleeve is connected to the transmission line at one end.

In order the test the concept of the invention, an implementation of the invention, as represented in the data hereinafter set forth, was constructed comprising two 50 ohm unbalanced to a balanced 50 ohm unit connected back to back. The test implementation used a 25 ohm semi rigid 0.07 diameter coax connected in series at the input and output of the back-to-back assembly. The conductive sleeve was positioned on the outside shield of a semirgid 50 ohm coax with a inner diameter of xxx. Two ferrite cores with a u of 40 with a inside diameter of xxx and a outside diameter of xxx were placed over the shield.

It is noted that if the coax length were a half wave length long, the short at the source end appears at the load end would destroy the balun operation. Therefore, the length of the balun should normally be under a half wave length long. However, disadvantageously, this requirement would severely limit the low frequency response possible. Thus, in order to expand the low frequency operation, the ferrite according to the invention was used around the coax.

The use of the ferrite according to the invention results in the parasitic line being electrically longer than the coax because the transmission medium for the parasitic line is through the magnetic material which has a high permeability and dielectric constant. Use of the conducting sleeve of the invention significantly diminishes this effect.

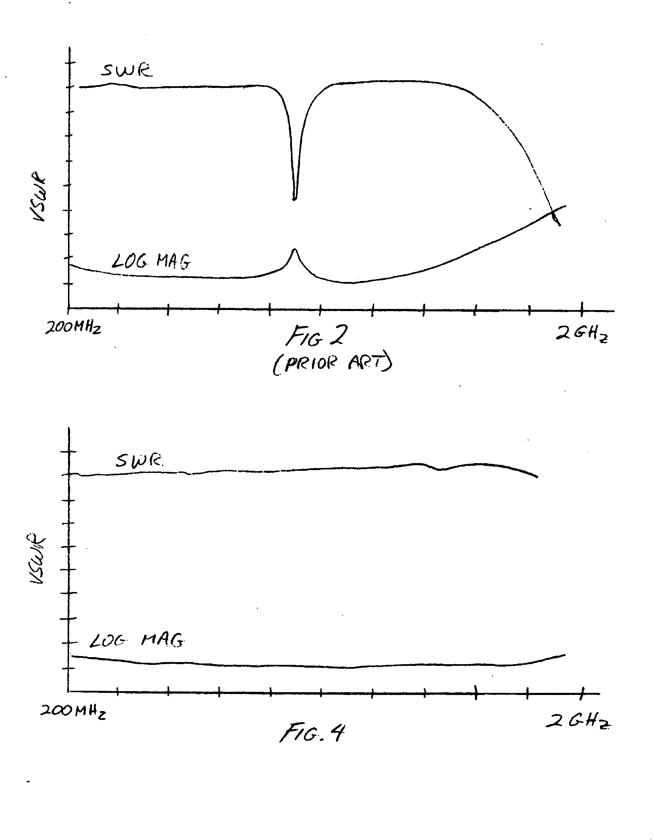

It is noted that further testing indicated that if the sleeve of the invention was not employed, large dips in its response were suffered. It is believed that the large dips in the response in the assembly without the sleeve was due to the parasitic line formed by the shield of the coax and ground using the ferrite core as part of the medium for the parasitic line. A representative VSWR without the use of the sleeve of the invention is shown in Fig. 2.

In summary, according to the present invention, the use of the conductive sleeve encompassing a tubular ferrite isolates the balun from the effects of ferrite at low frequency and thereby significantly reduces losses and improves VSWR. Many of the disadvantages associated with prior art ferrite baluns are therefore overcome.

The foregoing has outlined rather broadly the more pertinent and important features of the present invention in order that the detailed description of the invention that follows may be better understood so that the present contribution to the art can be more fully appreciated. Additional features of the invention will be described hereinafter which form the subject of the claims of the invention. It should be appreciated by those skilled in the art that the conception and the specific embodiment disclosed may be readily utilized as a basis for modifying or designing other circuits and assemblies for carrying out the same purposes of the present invention. It should also be realized by those skilled in the art that such equivalent circuits and assemblies do not depart from the scope of the invention as set forth in the appended claims.

For a fuller understanding of the nature and objects of the invention, reference should be had to the following detailed description of the preferred embodiment taken in connection with the accompanying drawings in which:
Fig. 1 is a longitudinal cross-sectional view of a prior art bazooka balun employing a sleeve;
Fig. 2 is a VSWR plot of a typical prior art ferrite balun;
Fig. 3 is a longitudinal cross-sectional view of a balun according to the present invention that employs a conductive sleeve encompassing a tubular ferrite installed over the terminal end of a coax feeder; and
Fig. 4 is a VSWR plot of the balun of Fig. 3.

Similar reference characters refer to similar parts throughout the several views of the drawings.

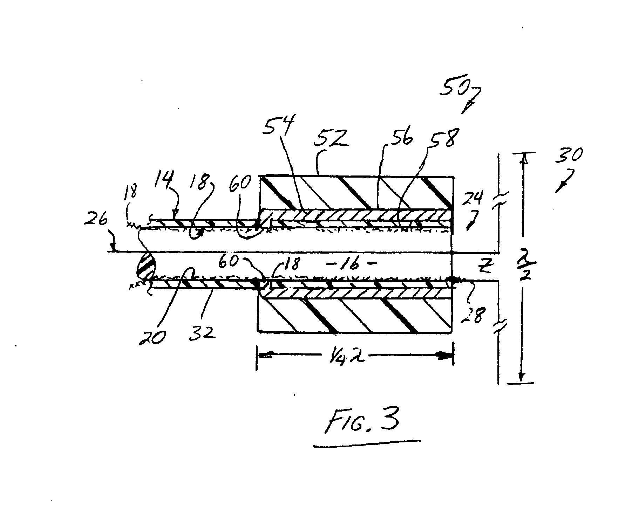

Referring to Fig. 3, the preferred embodiment of the balun 50 of the invention comprises a tubular ferrite 52 having a longitudinal passageway 54 concentrically positioned over a conductive sleeve 56 having a longitudinal 58 passageway. The proximal end 60 of the conductive sleeve 56 is preferably inwardly turned. Preferably, the tubular ferrite 52 and the conductive sleeve 56, along with their respective passageways 54 and 58, comprise circular cylindrical configurations.

In one application, the balun 50 of the invention is intended to be coupled over the end 16 of a 75Ω cable 14 and the conductive sleeve 56 shorted to the shield 18 of the cable 14 (i.e., its unbalanced line 20) only at its proximal end 60, such as by soldering, to reflect an open circuit at its feed point 24 of the cable's inner conductor 26.

The coupled conductive sleeve 56 forms a parasitic line from the shield 18 of the coax cable 14. The tubular ferrite 52 coupled to the sleeve 18 forms an additional parasitic line between the sleeve 56 and ground. The effect of the parasitic line which uses the ferrite 52 for its medium is buffered by the sleeve 56. When the parasitic line formed by the sleeve 56 and the shield 18 is a quarter wavelength, the impedance between the unbalanced line 20 and the end of the sleeve 56 is very high, thereby reducing the effect of the impedance from the end of the sleeve to ground.

The longitudinal passageway 58 of the conductive sleeve 56 may be dimensioned to fit tightly around the existing outer plastic mantle 32 of the cable 14. Alternatively, the mantle 32 may be removed and the longitudinal passageway 58 of the conductive sleeve 56 may be dimensioned to fit tightly around the shield 18 of the cable 14. Still alternatively, the mantle 32 may be replaced by or supplemented with a thicker dielectric spacer, with the diameter of the longitudinal passageway 58 of the conductive sleeve 56, and of the tubular ferrite 53, correspondingly increased.

The tubular ferrite 52 may dimensioned such that its longitudinal passageway 54 fits tightly around the conductive sleeve 56. Alternatively, the diameter of the longitudinal passageway 54 of the tubular ferrite 53 may be greater than the outer diameter of the conductive sleeve 56 to form a space therebetween, that itself may be filled with a dielectric spacer.

The wall thickness of the ferrite 52 and its permeability and the space between the ferrite 52 should be selected to optimize the performance of the balun. The following chart sets forth an example of an actual prototype:

| Tubular Ferrite Material | Ferronic-P Part Number 11-761P |
|---|---|
| Permeability of Tubular Ferrite | 40 |
| Diameter of Longitudinal Passageway of Tubular Ferrite (Inside Diameter of Core) | 0.71cm |
| Wall Thickness of Tubular Ferrite | 0. 27cm |
| Outside Diameter of Tubular Ferrite | 1.27cm |
| Spacing Between Outer Diameter of Sleeve and Diameter of Longitudinal Passageway of Tubular Ferrite (Inside Diameter of Core) | 0.17cm |

The balun 50 of the invention is principally intended to function as a balanced/unbalanced transformer for a load Z. For example, the balanced line 28 constituting the balun's load Z may comprise, as shown in Fig. 3, a half-wave dipole antenna 30. Alternatively, without departing from the scope of the invention, the balun 50 may be configured as a splitter or a combiner.

## Claims

1. A balun (50), comprising in combination:
a transmission line;
a shield (18) positioned about said transmission line;
a conductive sleeve (56);
said conductive sleeve (56) positioned about said transmission line and shorted to said shield (18), **characterised by**
a tubular ferrite (52) having a longitudinal passageway (54) in which said conductive sleeve (56) is positioned, and
wherein the length of said ferrite (52) and the length of said conductive sleeve (56) are of a quarter wavelength.

2. The balun (50) as set forth in Claim 1, wherein said longitudinal passageway (54) of said tubular ferrite (52) and said conductive sleeve (56) comprise circular cylindrical configurations.

3. The balun (50) as set forth in Claim 2, wherein said tubular ferrite (52) comprises at least one of a permeability of about 40 or a wall thickness of about 0.27cm.

4. A method for matching a balanced load to an unbalanced feed of a transmission line, comprising the steps of:
coupling a ferrite (52) to the transmission line to form a parasitic line;
coupling a conductive sleeve (56) to the ferrite (52) to buffer the parasitic line formed by coupling the ferrite (52) to the transmission line,
wherein said ferrite (52) comprises a tubular ferrite (52) having a longitudinal passageway (54) in which said conductive sleeve (56) is positioned, and
wherein the length of said ferrite (52) and the length of said conductive sleeve (56) are of a quarter wavelength.

5. The method as set forth in Claim 4, wherein said conductive sleeve (56) encompassing the ferrite (52) isolates the effects of ferrite at low frequency and thereby significantly reduces losses and improves VSWR.

6. The method as set forth in Claim 4, wherein said transmission line functions as a transformer.

7. The method as set forth in Claim 4, wherein said transmission line functions as a splitter.

8. The method as set forth in Claim 4, wherein said transmission line functions as a combiner.

## Patentansprüche

1. Balun (50), umfassend in Kombination:
eine Übertragungsleitung;
eine Abschirmung (18), die um die Übertragungsleitung herum angeordnet ist;
eine leitfähige Hülse (56),
wobei die leitfähige Hülse (56) um die Übertragungsleitung herum angeordnet ist und mit der Abschirmung (18) kurzgeschlossen ist,
**gekennzeichnet durch**
einen rohrförmigen Ferrit (52) mit einem Längsdurchgang (54), in dem die leitfähige Hülse (56) angeordnet ist, und
wobei die Länge des Ferrits (52) und die Länge der leitfähigen Hülse (56) eine viertel Wellenlänge betragen.

2. Balun (50) nach Anspruch 1, wobei der Längsdurchgang (50) des rohrförmigen Ferrits (52) und die leitfähige Hülse (56) kreiszylindrische Konfigurationen umfassen.

3. Balun (50) nach Anspruch 2, wobei der rohrförmige Ferrit (52) eine Permeabilität von ungefähr 40 und/oder eine Wanddicke von ungefähr 0,27 cm umfasst.

4. Verfahren zum Anpassen einer symmetrischen Last an eine unsymmetrische Speisung einer Übertragungsleitung, umfassend die Schritte:
Koppeln eines Ferrits (52) an die Übertragungsleitung, um eine parasitäre Leitung zu bilden;
Koppeln einer leitfähigen Hülse (56) an den Ferrit (52), um die parasitäre Leitung, die durch Koppeln des Ferrits (52) an die Übertragungsleitung gebildet ist, zu puffern,
wobei der Ferrit (52) einen rohrförmigen Ferrit (52) mit einem Längsdurchgang (54) umfasst, in dem die leitfähige Hülse (56) angeordnet ist, und
wobei die Länge des Ferrits (52) und die Länge der leitfähigen Hülse (56) eine viertel Wellenlänge betragen.

5. Verfahren nach Anspruch 4, wobei die leitfähige Hülse (56), die den Ferrit (52) umgibt, die Wirkungen des Ferrits bei niedriger Frequenz isoliert und dadurch Verluste erheblich reduziert und das Stehwellenverhältnis verbessert.

6. Verfahren nach Anspruch 4, wobei die Übertragungsleitung als Transformator fungiert.

7. Verfahren nach Anspruch 4, wobei die Übertragungsleitung als Splitter fungiert.

8. Verfahren nach Anspruch 4, wobei die Übertragungsleitung als Kombinator fungiert.

## Revendications

1. Symétriseur (50), comprenant en combinaison :
une ligne de transmission ;
un blindage (18) positionné autour de ladite ligne de transmission ;
une gaine conductrice (56) ;
ladite gaine conductrice (56) positionnée autour de ladite ligne de transmission et court-circuité sur ledit blindage (18),
**caractérisé par** une ferrite (52) tubulaire ayant un passage longitudinal (54) dans lequel ladite gaine conductrice (56) est positionnée, et
dans lequel la longueur de ladite ferrite (52) et la longueur de ladite gaine conductrice (56) sont un quart de longueur d'onde.

2. Symétriseur (50) selon la revendication 1, dans lequel ledit passage longitudinal (54) de ladite ferrite (52) tubulaire et ladite gaine conductrice (56) comprennent des configurations cylindriques circulaires.

3. Symétriseur (50) selon la revendication 2, dans lequel ladite ferrite (52) tubulaire comprend au moins une parmi une perméabilité d'environ 40 ou une épaisseur de paroi d'environ 0,27 cm.

4. Procédé d'adaptation d'une charge équilibrée à une alimentation non équilibrée d'une ligne de transmission, comprenant les étapes de :
couplage d'une ferrite (52) à la ligne de transmission pour former une ligne parasite ;
couplage d'une gaine conductrice (56) à la ferrite (52) pour séparer la ligne parasite formée par le couplage de la ferrite (52) à la ligne de transmission,
dans lequel ladite ferrite (52) comprend une ferrite (52) tubulaire ayant un passage longitudinal (54) dans lequel ladite gaine conductrice (56) est positionnée, et
dans lequel la longueur de ladite ferrite (52) et la longueur de ladite gaine conductrice (56) sont un quart de longueur d'onde.

5. Procédé selon la revendication 4, dans lequel ladite gaine conductrice (56) comprenant la ferrite (52) isole les effets de ferrite à basse fréquence et ainsi réduit les pertes et améliore le RTOS de façon significative.

6. Procédé selon la revendication 4, dans lequel ladite ligne de transmission fonctionne comme un transformateur.

7. Procédé selon la revendication 4, dans lequel ladite ligne de transmission fonctionne comme un diviseur.

8. Procédé selon la revendication 4, dans lequel ladite ligne de transmission fonctionne comme un combineur.
